Europäisches Patentamt

European Patent Office

Office européen des brevets

(19)

(11) **EP 0 554 424 B1**

(12) **FASCICULE DE BREVET EUROPEEN**

(45) Date de publication et mention
de la délivrance du brevet:
**11.12.1996 Bulletin 1996/50**

(21) Numéro de dépôt: **92917555.2**

(22) Date de dépôt: **26.08.1992**

(51) Int Cl.⁶: **G01R 21/133**, G01R 27/16,
G01R 27/26

(86) Numéro de dépôt international:
**PCT/CH92/00172**

(87) Numéro de publication internationale:
**WO 93/04377 (04.03.1993 Gazette 1993/06)**

(54) **PROCEDE POUR IDENTIFIER DES CHARGES CONSOMMATRICES D'ENERGIE ELECTRIQUE D'UN CIRCUIT SOUS SURVEILLANCE**

Verfahren zur Identifizierung von energieverbrauchenden Lasten in einem zu überwachenden Stromnetz

METHOD FOR IDENTIFYING ELECTRICAL POWER CONSUMERS ON A CIRCUIT BEING MONITORED

(84) Etats contractants désignés:
**AT BE CH DE FR GB IT LI NL SE**

(30) Priorité: **27.08.1991 FR 9110717**

(43) Date de publication de la demande:
**11.08.1993 Bulletin 1993/32**

(73) Titulaire: **SERVICES INDUSTRIELS DE GENEVE**
**CH-1200 Geneve (CH)**

(72) Inventeurs:
• **BENOIT, Pierre**
**CH-1249 Athenaz (CH)**
• **PASCHE, Sahr**
**CH-1092 Belmont (CH)**
• **CHAUVEAU, Jean-Marie**
**CH-2023 Gorgier (CH)**

(74) Mandataire: **Nithardt, Roland**
**Cabinet Roland Nithardt,**
**Conseils en Propriété Industrielle S.A.,**
**Y-Parc Scientifique et Technologique,**
**Chemin de la Sallaz,**
**Case postale 3347**
**1400 Yverdon-les-Bains (CH)**

(56) Documents cités:
**EP-A- 0 200 312**      **FR-A- 2 645 968**
**GB-A- 2 235 304**      **US-A- 4 858 141**

• **ELEKTRONIK vol. 35, no. 5, Mars 1986,**
**MUNCHEN DE pages 112 - 117;CHRISTIANSEN**
**ET AL:'AUTOMATISCHER**
**REAKTANZMESSPLATZ...'**
• **BULLETIN DES SCHWEIZERISCHEN**
**ELEKTROTECHNISCHEN VEREINS,vol. 68, no.**
**20, Octobre 1977, ZURICH CH pages 1081 -**
**1086;WEILER:'EXPERIMENTELLE**
**BESTIMMUNG ...'**

EP 0 554 424 B1

## Description

La présente invention concerne un procédé pour identifier des charges consommatrices d'énergie électrique d'un circuit sous surveillance et pour déterminer l'énergie consommée par chacune de ces charges.

Le but recherché par le procédé ci-dessus est d'analyser de manière très spécifique la consommation électrique des appareils chez un utilisateur en effectuant d'une manière "non invasive", c'est-à-dire sans être obligé d'installer chez cet utilisateur les nombreux capteurs, compteurs ou autres appareils de mesure habituellement requis, des mesures sur le courant et/ou la tension, et de classer les consommations par type ou nature. A titre d'exemple, un four électrique ou un fer à repasser ont une consommation purement résistive. Certaines charges dites réactives sont caractérisées par une impédance et/ou d'autres par une capacité, ce qui aboutit à un type de consommation électrique différente. Il est donc possible de classer les charges consommatrices d'énergie électrique selon leur nature, à savoir selon les valeurs de leur résistance, de leur impédance et de leur capacité.

Diverses méthodes ont été testées pour permettre d'analyser de manière fine la répartition de la consommation électrique par nature des charges consommatrices. Néanmoins, elles n'ont, à ce jour, pas abouti à des solutions efficaces permettant de stocker les résultats en vue de leur exploitation, sans faire appel à des capacités de mémoire incompatibles avec un équipement installé chez le consommateur.

Selon une technique antérieure décrite par le brevet américain $N^{\circ}$ 4 858 141, on mesure la puissance active RP et la puissance réactive PR ajustées en fonction de la tension mesurée. Cette mesure est rendue indépendante de la tension d'alimentation après mesure des paramètres $Y_G$ et $Y_C$ transformés en puissance active et réactive. On ne mentionne nulle part une mesure de phase.

Selon un dispositif décrit dans la publication européenne $N^{\circ}$ 0200312, on effectue une mesure de phase et on compare cette phase à un seuil prédéterminé afin de déclencher la charge en service si la valeur mesurée dépasse le seuil. Cette mesure de phase n'est pas utilisée pour effectuer une classification des charges par catégories.

Selon un appareil faisant l'objet de la publication britannique $N^{\circ}$ 2 235 304, un dispositif annexe à un compteur électrique mesure la fréquence de ses impulsions. Il existe une relation de proportionnalité entre la consommation effective d'une charge et la fréquence des impulsions. Grâce à une table mémorisée dans le dispositif, on peut déterminer une "classe" correspondant à une charge qui a été mise en service ou déconnectées à partir d'une détection des sauts de fréquence des impulsions du compteur. Ce dispositif est incapable de faire la distinction entre différentes charges. Par exemple, il ne permettra pas de distinguer la charge due à un aspirateur de 750 W et celle due à une plaque de cuisson de la même puissance.

Enfin, selon une technique décrite par la publication française $N^{\circ}$ 2 645 968, on mesure des signaux transitoires propres aux charges à l'enclenchement. La mesure se fonde sur la reconnaissance de la variation d'intensité, la détermination de la charge à partir de cette information et la mesure de la tension. On fait en outre appel à une fréquence d'échantillonnage et non à des états stables.

La présente invention se propose de pallier les inconvénients de l'art antérieur en mettant à disposition un procédé simple et efficace qui peut être appliqué quel que soit le nombre de charges de natures différentes sur le circuit sous surveillance concerné.

Ce but est atteint par le procédé selon l'invention caractérisé en ce que l'on effectue sur le courant électrique d'alimentation de ce circuit des mesures appropriées pour déterminer les variations d'impédance au cours du temps, en ce que l'on identifie les charges en déterminant la nature des variations d'impédance, en ce que l'on calcule l'énergie consommée pour chaque type de charge préalablement identifiée, en ce que l'on effectue sur le courant électrique d'alimentation de ce circuit des mesures appropriées pour déterminer les variations d'impédance au cours du temps, en ce que l'on identifie les charges en déterminant la nature des variations d'impédance, en ce que l'on calcule l'énergie consommée pour chaque type de charge préalablement identifiée, en ce que l'on analyse les variations d'impédance en déterminant la part due à une influence en amplitude et la part due à une influence en phase et en ce que l'on analyse les variations d'impédance en déterminant les variations de l'amplitude et de la phase de la charge connectée entre deux états stables successifs et l'on classe, à chaque variation d'impédance, l'écart de charge calculé dans une table des charges enclenchées, chaque classe correspondant à des charges dont les caractéristiques, à savoir amplitude et phase, sont déterminées.

Selon un premier mode de réalisation, lesdites mesures appropriées pour déterminer les variations d'impédance consistent à mesurer le rapport des amplitudes de l'intensité du courant et de la tension et leur déphasage.

Selon un deuxième mode de réalisation, lesdites mesures appropriées pour déterminer les variations d'impédance consistent à mesurer les amplitudes de l'intensité du courant et de la tension, à calculer leur rapport et à mesurer le déphasage entre l'intensité du courant et la tension.

Ensuite dans cette forme de réalisation, l'on détermine par unité d'énergie électrique consommée la contribution à la consommation dans chacune des classes définies de cette table et l'on somme lesdites contributions pour chacune desdites classes.

Enfin, l'on ajuste régulièrement la contribution à la consommation dans chacune des classes de consommation définies après des périodes de consommation prédéterminées.

La présente invention sera mieux comprise en référence à la description d'une forme de mise en oeuvre préférée et d'une variante avantageuse.

Selon un premier mode de réalisation du procédé de l'invention, la mesure à un instant donné de l'intensité $I$ du courant et du déphasage entre l'intensité $I$ et la tension $V$ dans le circuit sous surveillance permet de déterminer l'impédance $Z$ d'un appareil qui est enclenché dans ce circuit. Ce calcul s'effectue sur la base de la formule suivante:

$$V = Z.I$$

Si l'on considère que la tension $V$ du réseau d'alimentation est constante au moment de l'enclenchement d'un appareil, l'impédance déterminée sur le circuit passe d'une valeur $Z_0$ $(I_0, \varphi_0)$ à une valeur $Z_1$ $(I_1, \varphi_1)$. De la même manière au moment du déclenchement de cet appareil et/ou d'un autre appareil de ce circuit l'impédance passe de la valeur $Z_1$ $(I_1, \varphi_1)$ à la valeur $Z_2$ $(I_2, \varphi_2)$. Dans le cas particulier où ce seul appareil est déclenché, il est évident que $I_2 = I_0$ et $\varphi_2 = \varphi_0$. Cette variation $\Delta Z$ permet de déterminer la nature de la charge consommatrice d'énergie qui a été enclenchée ou déclenchée. On classe cette variation d'impédance $\Delta Z$ dans l'espace des impédances $(I, \varphi)$, ce qui permet d'attribuer à chaque variation d'impédance, une classe de consommation. Chaque fois qu'on constate que l'impédance $Z$ effectue un saut $\Delta Z$, un appareil dont la consommation en énergie électrique $P$ est égale à

$$P = 1/2 \ (V)^2/\Delta Z$$

a été connecté ou retiré du circuit sous surveillance.

En mesurant et en calculant le rapport des amplitudes de l'intensité du courant et de la tension, on élimine les possibles erreurs de calcul qui pourraient être dues à une variation de la tension d'alimentation du réseau électrique.

Dans la description ci-dessous on parlera d'énergie électrique en kilowatts et non pas en kilowattheures, ce qui est une notion commode couramment employée dans le milieu des professionnels liés à la distribution d'énergie électrique, et qui correspond à une puissance moyenne appelée par une charge dans un intervalle de temps prédéterminé qui peut être une heure, un jour voire une année.

Etant donné que l'on peut déterminer, à partir de la variation d'impédance $\Delta Z$, la phase et l'amplitude de la charge consommatrice enclenchée ou déclenchée, il est possible de classer l'énergie effectivement consommée dans des classes correspondant à la nature de ces charges consommatrices, ces classes étant appelées classes de consommation.

Dans le cas de courant triphasé, les mesures et le classement s'effectuent pour chacune des phases et prennent en compte la simultanéité des variations sur les phases pour regrouper les calculs.

Dans le circuit concerné, il est possible de déterminer pour chaque kilowatt, multiple ou sous-multiple de kilowatt consommé la contribution de chaque charge à la consommation de cette énergie électrique.

La mémorisation complète des quantités d'énergie effectivement consommées pour chaque classe de consommation nécessiterait des capacités de mémoire très importantes qui ne sont pas compatibles avec une intégration dans un compteur domestique. C'est pourquoi, dans le cadre du procédé ci-dessus on détermine des coefficients $C_1$, $C_2$,...$C_n$ qui définissent la contribution des appareils enclenchés de chaque classe de consommation à la consommation globale pour une unité d'énergie électrique consommée utilisée comme sous-période de mesure.

En outre on peut recourir à une simplification pour évaluer les coefficients $C$. Par exemple si un appareil demeure enclenché pendant toute la sous-période de mesure, son coefficient $C$ est égal à 100. En d'autres termes, la contribution de l'appareil à la consommation globale dans la classe de consommation correspondant à l'appareil est de 100%. Si un appareil est enclenché ou déclenché pendant la sous-période de mesure le coefficient $C$ devient égal à 50 et si l'appareil enclenché pendant cette sous-période est ensuite déclenché pendant la même sous-période, le coefficient $C$ est alors égal à 25.

Pour certains compteurs sur lesquels chaque kilowatt est subdivisé en au moins 240 périodes distinctes, l'approximation est proche de la réalité.

Pour réaliser une telle approximation le programme de calcul maintient par classe de consommation une table telle que représentée ci-dessous

| Classes | Puiss. inst.des classes | Encl. $N_e$ | Décl. $N_d$ | C | % e | $N_o$ | % $E_o$ | % $E'_o$ | $N'_o$ |
|---------|-------------------------|-------------|-------------|---|-----|-------|---------|----------|--------|
| 1 | $P_1$ | | | | | | | | |
| 2 | $P_2$ | | | | | | | | |

(suite)

| Classes | Puiss. inst.des classes | Encl. $N_e$ | Décl. $N_d$ | C | % e | $N_o$ | % $E_o$ | % $E'_o$ | $N'_o$ |
|---|---|---|---|---|---|---|---|---|---|
| . . . | | | | | | | | | |
| i | $P_i$ | $N_{ie}$ | $N_{id}$ | $C_i$ | ei | $N_{io}$ | $E_{io}$ | $E'_{io}$ | $N'_{io}$ |
| . . . | | | | | | | | | |
| k-1 | $P_{k-1}$ | | | | | | | | |
| k | $P_k$ | | | | | | | | |
| | | | | | | | | | |
| | | $N_{ie}$ | $N_{id}$ | $S_1$ | 100% | | 100% | 100% | |
| | | | | | U | | $S_2$ | $S_2 + U$ | |

où sont conservés par sous-période de mesure:

- le nombre d'appareils $N_o$ enclenchés au début
- le nombre d'appareils $N_e$ qui se sont enclenchés en cours de chaque sous-période de mesure
- le nombre d'appareils $N_d$ enclenchés qui se sont déclenchés en cours de chaque sous-période de mesure.

A la fin de la sous-période de mesure définie par une impulsion du compteur, ce compteur étant équipé d'une électronique appropriée, on calcule:

- le solde des appareils qui sont enclenchés à la fin de la période de mesure

$$N'_o = N_o - N_d + N_e \tag{1}$$

- la variation du nombre d'appareils enclenchés ou déclenchés pendant cette période de mesure

$$\Theta N = N'_o - N_o = N_e - N_d \tag{2}$$

- le nombre d'appareils $N_{ed}$ enclenchés et déclenchés en cours de cycle

$$N_{ed} = N_e + N_d - |N_e - N_d| \tag{3}$$

Le coefficient $C_i$ correspondant à la contribution de la classe (i) sera alors pondéré comme indiqué précédemment:

$$C_i = N_{io} + 0,5\Theta N + 0,25 N_{ed} \tag{4}$$

A chaque classe d'appareils correspond une puissance instantanée consommée par un appareil de la classe, qui dérive de la formule classique

$$P_i = 1/2\, Z_i\, I^2 = 1/2\, V^2/Z_i \tag{5}$$

où $Z_i$ est l'impédance de la classe.

Pendant la sous-période de mesure définie par une impulsion du compteur, la contribution C de la classe à la consommation est proportionnelle à

$$C_i \text{ x } P_i \tag{6}$$

On peut alors calculer la somme $S_1$ des contributions de toutes les classes pendant la sous-période de mesure

$$S_1 = \Sigma C_i \text{ x } P_i \tag{7}$$

puis, pour chaque classe, la contribution effective $e_i$ en % à la consommation d'une unité d'énergie

$$e_i = C_i \text{ x } P_i / S1 = C \text{ x } P / \Sigma \ C_i \text{ x } P_i \tag{8}$$

Des totalisateurs permettent de connaître la consommation de l'abonné contrôlée pendant une campagne de mesures, par classe de consommation. Cette campagne de mesure peut se diviser en quatre périodes temporelles. La première période de base est celle que constitue la mise en place du système de mesure sur le compteur de l'abonné jusqu'à son retrait. La seconde période est celle qui sépare les passages successifs de l'employé chargé de relever les mesures. Cette période peut être variable. Elle est connue par sa date et son heure de début $D_d$ et par sa date et son heure de fin $D_f$ et la somme des secondes périodes est égale à la première période définie ci-dessus. La troisième période est celle de la semaine. Elle permet de définir un cycle naturel chez les usagers et d'effectuer des consolidations de résultats. La quatrième période est celle de la journée qui présente aussi des cycles de consommation usuelle. Une tranche horaire de la journée concernée définit une sous-période de totalisation.

Les totalisateurs sont incrémentés chaque fois que le système de mesure a enregistré la consommation d'un kilowatt ou d'un multiple et le programme de calcul somme dans chaque classe étudiée les contributions calculées relevées après les avoir pondérées.

Un compteur général additionne les kilowatts mesurés depuis le début de la sous-période de totalisation. Ce compteur est remis à zéro lorsqu'on détecte, en fonction du temps $T_f$, le passage d'une sous-période de totalisation à la suivante.

Si $S_2$ est le nombre de kilowatts consommés avant le début de la sous-période de mesure et si, à chaque classe, on associe un totalisateur de la contribution $E_{io}$ exprimée en %, on a

$$\Sigma \ E_{io} = 100 \ \% \tag{9}$$

Si $U$ est l'énergie consommée durant les sous-périodes de mesure, à la fin de chaque sous-période de mesure on calcule pour chaque classe la nouvelle valeur $E'_{io}$ en % du totalisateur

$$E'_{io} = (E_{io}{}^*S_2 + e_i{}^*U) / S_2 + U \tag{10}$$

A la fin de la sous-période de mesure, le compteur du nombre de kilowatts consommés est ensuite incrémenté de la quantité $U$

$$S'_2 = S_2 + U \tag{11}$$

Au début de la sous-période suivante l'électronique du compteur remet ses tables à une condition de début, c'est-à-dire, pour chaque classe

- ajuste le nombre d'appareils enclenchés $N_{io} = N'_{io}$
- ajuste le totalisateur de la contribution $E_{io} = E'_{io}$
- remet les totalisateurs de modifications et de contribution à zéro.

Le maintien des totalisateurs en % a été préféré à une totalisation en kilowatts pour une raison de normalisation des calculs et pour pouvoir facilement changer les paramètres d'initialisation du programme de calcul, par exemple le nombre d'impulsions du compteur définissant la sous-période de mesure et l'énergie correspondante mesurés.

Les totalisateurs sont incrémentés selon le même principe durant une fenêtre temporelle de la journée, par exemple entre 12 et 13 heures, tous les jours, ou certains jours de la semaine.

A la fin de la sous-période de totalisation les totalisateurs sont consolidés (sommés et mémorisés) selon le même principe de variables indépendantes dans les tables journalières (par exemple six tables journalières).

Ces tables journalières permettent de définir le profil de la semaine. Lorsque le cycle de la semaine recommence, à la fin de chaque sous-période de totalisation, la table correspondante des totalisateurs est consolidée, toujours selon le même principe de variables indépendantes, dans la table journalière du jour de la semaine correspondante (six tables journalières pour sept jours = quarante-deux tables).

Ces quarante-deux tables (ou plus) sont sauvegardées dans un dispositif de mémoire de masse associé au dispositif de mesure non invasive. Cette mémoire de masse est retirée par un employé chargé de relever les mesures (semaine ou mois) qui remet en place un dispositif de mémoire de masse qui a été reformaté et dans lequel seront enregistrés les nouveaux paramètres.

Dans une autre forme de réalisation le relevé des mesures peut se faire par un transfert des données enregistrées, dans la mémoire d'un ordinateur portable connecté par l'employé. Dans ce cas le dispositif de mémoire de masse est maintenu en place et reformaté après le transfert pour une nouvelle série de mesures.

La période de mesure peut être variable. Elle est connue par sa date et son heure de début et par sa date et son heure de fin. Un enregistrement séquentiel des consommations est effectué sur la base de quarts d'heure ou de demi-heures. Cependant des problèmes de temps réels peuvent voir le jour si les systèmes de mesure doivent acquérir trop de paramètres. Dans ce cas, la période d'acquisition sera élargie en ne faisant une acquisition traitement que tous les **n** impulsions compteur.

En effet si la consommation de l'usager est très élevée le compteur tourne plus rapidement et les impulsions se suivent à une fréquence trop rapide pour permettre une acquisition en temps réel. Il suffit alors de sauter une impulsion sur deux ou trois pour recréer une période d'acquisition compatible avec la vitesse d'acquisition.

**Revendications**

1. Procédé pour identifier des charges consommatrices d'énergie électrique d'un circuit sous surveillance et pour déterminer l'énergie effectivement consommée par chacune des ces charges, caractérisé en ce que l'on effectue sur le courant électrique d'alimentation de ce circuit des mesures appropriées pour déterminer les variations d'impédance au cours du temps, en ce que l'on identifie les charges en déterminant la nature des variations d'impédance, en ce que l'on calcule l'énergie consommée pour chaque type de charge préalablement identifié, en ce que l'on analyse les variations d'impédance en déterminant la part due à une influence en amplitude et la part due à une influence en phase et en ce que l'on analyse les variations d'impédance en déterminant les variations de l'amplitude et de la phase de la charge connectée entre deux états stables successifs et l'on classe, à chaque variation d'impédance, l'écart de charge calculé dans une table des charges enclenchées, chaque classe correspondant à des charges dont les caractéristiques, à savoir amplitude et phase, sont déterminées.

2. Procédé selon la revendication 1, caractérisé en ce que lesdites mesures appropriées pour déterminer les variations d'impédance consistent à mesurer le rapport des amplitudes de l'intensité du courant et de la tension et leur déphasage.

3. Procédé selon la revendication 1, caractérisé en ce que lesdites mesures appropriées pour déterminer les variations d'impédance consistent à mesurer les amplitudes de l'intensité du courant et de la tension, à calculer leur rapport et à mesurer le déphasage entre l'intensité du courant et la tension.

4. Procédé selon la revendication 1, caractérisé en ce que l'on détermine par unité d'énergie électrique consommée la contribution à la consommation dans chacune des classes définies de cette table.

5. Procédé selon la revendication 4, caractérisé en ce que l'on somme lesdites contributions pour chacune desdites classes.

6. Procédé selon la revendication 4, caractérisé en ce que l'on ajuste régulièrement la contribution à la consommation dans chacune des classes de consommation définies après des périodes de consommation prédéterminées.

**Patentansprüche**

1. Verfahren zur Identifizierung von energieverbrauchenden Lasten in einem zu überwachenden Stromnetz und zur Bestimmung der durch jede dieser Lasten tatsächlich verbrauchten Energie, **dadurch gekennzeichnet,** daß man an dem elektrischen Strom zur Versorgung dieses Stromkreises geeignete Messungen vorgenommen werden, um die Veränderungen des Scheinwiderstandes über die Zeit zu bestimmen, daß die Belastungen identifiziert werden, indem die Art der Veränderungen des Scheinwiderstandes bestimmt werden, daß für jeden vorher identifizierten Belastungstyp die verbrauchte Energie berechnet wird, daß die Scheinwiderstandsveränderungen analysiert werden, indem der Anteil, der auf eine Einwirkung in die Amplitude zurückzuführen ist, und der Anteil, der auf eine Einwirkung in der Phase zurückzuführen ist, bestimmt wird, und daß die Veränderungen des Scheinwiderstandes analysiert werden, indem die Veränderungen der Amplitude und der Phase der Belastung zwischen zwei aufeinanderfolgenden stabilen Zuständen bestimmt werden und indem bei jeder Veränderung des Scheinwiderstandes die Abweichung der berechneten Belastung in einer Tabelle für die eingeschalteten Belastungen klassifiziert wird, wobei jede Klasse Belastungen entspricht, deren Merkmale, nämlich Amplitude und Phase, ermittelt sind.

2. Verfahren nach Anspruch 1, **dadurch gekennzeichnet,** daß die geeigneten Messungen zum Bestimmen der Scheinwiderstandsveränderungen darin bestehen, daß das Amplitudenverhältnis der Stromstärke und der Spannung sowie ihre Phasenverschiebung gemessen werden.

3. Verfahren nach Anspruch 1, **dadurch gekennzeichnet,** daß die geeigneten Messungen zum Bestimmen der Scheinwiderstandsveränderungen darin bestehen, daß die Amplituden der Stromstärke und der Spannung gemessen, ihr Verhältnis berechnet und die Phasenverschiebung zwischen der Stromstärke und der Spannung gemessen werden.

4. Verfahren nach Anspruch 1, **dadurch gekennzeichnet**, daß über die verbrauchte elektrische Energieeinheit der Beitrag zum Verbrauch in jeder der in dieser Tabelle definierten Klassen ermittelt wird.

5. Verfahren nach Anspruch 4, **dadurch gekennzeichnet,** daß diese Beiträge für jede dieser Klassen summiert werden.

6. Verfahren nach Anspruch 4, **dadurch gekennzeichnet,** daß regelmäßig der Beitrag jeder der nach vorbestimmten Verbrauchsintervallen definierten Verbrauchsklassen am Verbrauch angepaßt wird.

**Claims**

1. Method for identifying equipment which consumes electrical energy on a circuit being monitored and for determining the effective energy consumption by each piece of equipment, characterized in that appropriate measurements are made on the electrical supply current to determine variations in impedance over time, in that the loads are identified by determining the nature of the impedance variations, in that the energy consumed by each type of previously identified load is calculated, in that impedance variations are analyzed by determining the portion due to amplitude effect and the portion due to phase effect and in that impedance variations are analyzed by determining the variations in amplitude and in phase of the load connected between two successive stable states and that for each variation in impedance, the load difference is classified on a table of operating loads, each class corresponding to loads whose characteristics, that is, amplitude and phase, are determined.

2. Method according to claim 1 characterized in that said appropriate measurements for determining impedance variations consists of measuring the relationship between current intensity amplitudes and voltage intensity amplitudes, and dephasing.

3. Method according to claim 1 characterized in that said appropriate measurements for determining impedance variations consists of measuring current intensity amplitudes and voltage intensity amplitudes, calculating their relationship and measuring dephasing between current intensity and voltage intensity.

4. Method according to claim 1 characterized in that the contribution to consumption of each class which is defined in the table is determined by unit of electrical energy consumed.

5. Method according to claim 4 characterized in that said contributions are totalled for each of said classes.

6. Method according to claim 4 characterized in that the contributions of each of these defined classes to consumption is regularly adjusted after predetermined consumption periods.